# EUROPÄISCHE PATENTSCHRIFT

(11) **EP 3 653 363 B1**
(45) Veröffentlichungstag und Bekanntmachung des Hinweises auf die Patenterteilung: **04.09.2024**
(21) Anmeldenummer: 19202490.9
(22) Anmeldetag: 10.10.2019
(51) Int. Cl.: B29C 64/321, G02B 21/33, B29C 64/106, B29C 64/209, B29C 64/268, B29C 64/336, B33Y 30/00, G03F 7/16, G03F 7/20

(54) **VERWENDUNG EINES DISPENSER-AUFSATZES FÜR EINE VORRICHTUNG ZUM SCHREIBEN VON 3D-STRUKTUREN MITTELS LASERLITHOGRAFIE**
USE OF A DISPENSER ATTACHMENT FOR A DEVICE FOR WRITING 3D STRUCTURES BY MEANS OF LASER LITHOGRAPHY
UTILISATION D'UN ADAPTATEUR DE DISTRIBUTION POUR UN DISPOSITIF D'ÉCRITURE DE STRUCTURES TRIDIMENSIONNELLES PAR LITHOGRAPHIE LASER

(30) Priorität: 13.11.2018 DE 102018128418
(43) Veröffentlichungstag der Anmeldung: 20.05.2020
(73) Patentinhaber: Nanoscribe Holding GmbH, 76344 Eggenstein-Leopoldshafen (DE)
(72) Erfinder: Hoffmann, Jörg, 67363 Lustadt (DE); Sauter, Thomas, 69151 Neckargemünd (DE); Linden, Christoph, 76275 Ettlingen (DE); Schach, Christian, 76137 Karlsruhe (DE)
(74) Vertreter: DREISS Patentanwälte PartG mbB

(56) Entgegenhaltungen:
- US-A- 3 837 731
- US-A1- 2010 027 109
- US-A1- 2012 218 535
- US-B2- 6 713 772
- US-B2- 9 927 702

## Beschreibung

Die Erfindung betrifft eine Verwendung eines Dispenser-Aufsatzes für Objektive auf dem Gebiet der Laserlithografie.

Die im vorliegenden Zusammenhang mit Laserlithografie bezeichnete Technik wird beispielsweise auch als Stereo-Lithografie oder direktes Laserschreiben (englisch: direct laser typing) bezeichnet. Bei dieser Technik werden Strukturen mittels eines Schreibstrahls in eine in der Regel zunächst flüssige, fotosensitive Substanz geschrieben, die im vorliegenden Zusammenhang als Lithografiefluid bezeichnet wird. Hierbei wird durch die Laserstrahlung des Schreibstrahls in dem Lithografiefluid lokal ein Verfestigungseffekt ausgelöst. Die Verfestigung erfolgt dabei beispielsweise aufgrund einer durch Photonen-Absorption induzierte, lokale Polymerisation des Lithografiefluides. Im Bereich der optischen Lithografie werden Lithografiefluide auch als Fotolacke bezeichnet.

Die Technik der Laserlithografie bzw. des direkten Laserschreibens wird in vorteilhafterweise bei der Erzeugung von Mikro- oder Nanostrukturen eingesetzt, wenn eine hohe Präzision erwünscht ist und gleichzeitig Gestaltungsfreiheit und Flexibilität in der Formgebung erhalten bleiben soll. Anders als z.B. bei Verfahren der Maskenlithografie können nämlich verschiedene Strukturen geschrieben werden, ohne dass die Struktur durch eine Maske oder Ähnliches vorgegeben ist.

Grundsätzlich ist es hierbei bekannt, dass die gewünschte Gesamtstruktur dadurch erzeugt wird, dass sequentiell eine Reihe von Teilstrukturen geschrieben werden, die sich dann insgesamt zu der gewünschten Struktur ergänzen. Üblicherweise werden die Gesamtstrukturen lagenweise oder scheibenweise geschrieben. Hierzu trifft bei bekannten Techniken der Schreibstrahl auf die Oberfläche eines Volumens an Lithografiefluid und führt an der Oberfläche zu einer lokalen Verfestigung. Um dreidimensional ausgedehnte Strukturen zu schreiben, wird bei derartigen Verfahren nach dem Beschreiben einer Lage in einem Applikationsschritt eine zusätzliche Lage Lithografiefluid aufgetragen. Dies kann beispielsweise dadurch erreicht werden, dass ein Substrat mit der hierauf zu schreibenden Struktur schrittweise in einem Bad aus Lithografiefluid abgesenkt wird und die Strukturierung mittels des Schreibstrahls jeweils an der Oberfläche erfolgt.

Ein anderer Ansatz nutzt das physikalische Prinzip der Zwei-Photonen-Polymerisation oder allgemein Multi-Photonen-Polymerisation aus, um eine Verfestigung von Lithografiefluid auch innerhalb eines Volumens an Lithografiefluid, also auch unterhalb der Oberfläche zu erzielen.

Dies wird dadurch ermöglicht, dass Schreibstrahl und Lithografiefluid derart aufeinander abgestimmt sind, dass ein Verfestigungseffekt unter Mitwirkung nichtlinearer Effekte erfolgt. Beispielsweise wird der Schreibstrahl in einem Spektralbereich gewählt, der normalerweise keinen Verfestigungseffekt in dem Lithografiefluid auslösen kann. Beispielsweise können Lithografiefluid und Schreibstrahl derart aufeinander abgestimmt sein, dass eine induzierte Verfestigung nur durch Strahlung erfolgen könnte, die eine Wellenlänge aufweist, welche einem Bruchteil (insbesondere einen ganzzahligen Bruchteil) der Wellenlänge des tatsächlich verwendeten Schreibstrahls entspricht. Dadurch ist ein Verfestigungsprozess nur unter gleichzeitiger Absorption von zwei oder mehr Photonen des Schreibstrahls möglich (Zwei-Photonen-Polymerisation oder Multi-Photonen-Polymerisation). Im vorliegenden Zusammenhang wird mit dem Begriff Multi-Photonen-Polymerisation die induzierte Polymerisation durch gleichzeitige Absorption von zwei oder mehr als zwei Photonen bezeichnet. Insofern schließt für die vorliegende Beschreibung der Begriff "Multi-Photonen-Absorption" auch den Prozess der "Zwei-Photonen-Absorption" mit ein. Die für eine Multi-Photonen-Polymerisation erforderlichen Bedingungen werden in der Regel nur in einer Zone erhöhter Intensität erreicht. Diese Zone erhöhter Intensität wird in einem Fokusbereich des Schreibstrahls bereitgestellt. Der Fokusbereich ist insofern eine Strahltaille des Schreibstrahls, welche durch geeignete Optiken (z.B. Strahlführungsoptik, Strahlformungsoptik und/oder ein Objektiv) erzeugt wird. Zur lithografischen Herstellung von ausgedehnten 3D-Strukturen kann dann der Fokusbereich nach Maßgabe von Geometriebeschreibungsdaten durch ein Volumen an Lithografiefluid bewegt werden und jeweils lokal einen Verfestigungsprozess auslösen.

Eine entsprechende Technik ist beispielsweise in der DE 101 11 422 A1 beschrieben, welche 3D-Laserlithografie unter Ausnutzung von Multi-Photonen-Polymerisation innerhalb eines Bades aus Lithografiematerial in einem Behälter zeigt. Die hierzu beschriebene Vorrichtung weist eine Austrittsoptik zur Fokussierung des Laserstrahls auf einen Fokusbereich innerhalb des Behälters auf. Weitere Lithografie-Verfahren unter Ausnutzung von Multi-Photonen-Polymerisation sind aus US 6 713 772 B2 und US 2012/0218535 A1 bekannt.

Aus dem Bereich der Mikroskopie ist es bekannt, ein Objektiv eines Mikroskops mit seiner Abschlusslinse in ein Immersionsöl einzutauchen. Hierzu sind Immersionsöl-Dispenser in der Art eines Aufsatzes für Mikroskopie-Objektive bekannt. Beispielsweise zeigen die US 2010/0027109 A1 und US 3,837, 731 B Immersionsöl-Dispenser zum Aufsetzen auf ein Mikroskopie-Objektiv. Diese Dispenser weisen ein Gehäuse auf, welches beim Aufsetzen auf ein Objektiv eine Fluid-Kammer definiert, welche in einen Austrittsspalt mündet, der die Abschlusslinse des Objektivs in der Regel ringartig umgibt. In dem Fluidraum wird dann Immersionsöl bereitgestellt und kann durch den Austrittsspalt austreten. Das Eintauchen in Immersionsöl erfolgt im Bereich der Mikroskopie zu dem Zweck, die Abbildungsqualität und Auflösung zu verbessern. Aus der US 9 927 702 B2 ist zudem ein halbeintauchbares Mikroskopieobjektiv bekannt.

Bei Techniken zur Mikro- oder Nanostrukturierung ist es grundsätzlich erwünscht, die Durchsatzrate zu erhöhen und die Technik nutzbar zur Herstellung großer Stückzahlen zu machen. Insbesondere ist es erwünscht, nach dem Schreiben einer Struktur schnell das Substrat auswechseln zu können. Für jede einzelne Struktur soll es möglich sein, auch große Strukturtiefen erzeugen zu können und/oder die Struktur über große Flächen ausgedehnt erzeugen zu können. Um ausgedehnte Strukturen zu erzeugen, muss bei den genannten Techniken Lithografiefluid in einem ausreichend großen Volumen bereitgestellt werden und ggf. nachgeliefert werden. Dies ist nicht unproblematisch, da Lithografiefluide mit der Zeit teilweise degradieren oder unerwünschte Veränderungen erfahren können, was die Qualität der erzeugten Strukturen beeinträchtigen kann.

Es stellt sich die Aufgabe, bei Laserlithografie bzw. direktem Laserschreiben das Lithografiefluid in geeigneter Weise frei zu setzen und bei Bedarf nachzuliefern.

Diese Aufgabe wird durch die Verwendung eines Dispensers bzw. eines Dispenser-Aufsatzes gemäß den Verwendungsschritten nach Anspruch 1 gelöst.

Der Dispenser-Aufsatz wird in einer Vorrichtung zum Schreiben von dreidimensionalen Strukturen mittels Laserlithografie in einem Lithografiefluid verwendet. Eine solche Vorrichtung umfasst eine Laserstrahlquelle zur Abgabe eines Schreibstrahls sowie in der Regel ein Substrat, auf dem ein Volumen an Lithografiefluid aufgenommen und bereitgestellt werden kann. Das Lithografiefluid ist mittels des Schreibstrahls zur Erzeugung einer Struktur lokal verfestigbar. Die Vorrichtung umfasst außerdem verschiedene optische Komponenten, beispielsweise eine Strahlführungs- und Lenkungseinrichtung und ein Objektiv zur Führung des Schreibstrahls und zur Ausbildung eines Fokusbereichs des Schreibstrahls in dem Lithografiefluid. Im vorliegenden Zusammenhang ist insbesondere das Objektiv von Bedeutung. Das Objektiv umfasst ein Objektivgehäuse mit einer Abschlusslinse, durch welche der Schreibstrahl aus dem Objektiv austritt. Im vorliegenden Zusammenhang wird mit dem Begriff Abschlusslinse ganz allgemein dasjenige optische Element bezeichnet, welches den Übergang vom Objektiv in die Umgebung bildet. Die Abschlusslinse kann ein Linsenmittel im eigentlichen Sinne sein (z.B. Sammellinse). Die Abschlusslinse muss jedoch nicht zwingend eine optische Linsenwirkung aufweisen, sondern kann z.B. auch als Abschlussfenster ausgebildet sein.

Der verwendete Dispenser-Aufsatz umfasst ein insbesondere kappenartiges Dispenser-Gehäuse, welches dazu ausgebildet ist, auf das Objektiv bzw. auf das Objektivgehäuse aufgesetzt zu werden. Dabei ist das Dispenser-Gehäuse derart ausgestaltet, dass beim Aufsetzen ein Fluidraum zwischen Objektivgehäuse und Dispenser-Gehäuse ausgebildet ist. Der Fluidraum mündet in einen Austrittsspalt, welcher zwischen Dispenser-Gehäuse und Abschlusslinse des Objektivs gebildet ist. Durch den Austrittsspalt kann Fluid aus dem Fluidraum in einen Raumbereich vor der Abschlusslinse austreten. Insbesondere weist das Dispenser-Gehäuse eine Öffnung im Bereich der Abschlusslinse derart auf, dass ein Ringspalt zwischen einem Öffnungsrand und der Abschlusslinse gebildet wird. Der Dispenser-Aufsatz umfasst außerdem einen Fluidzugang in den Fluidraum zum Zuführen von Fluiden in den Fluidraum, so dass kontinuierlich Fluid durch den Austrittsspalt austreten kann.

Für die beanspruchte Verwendung werden verschiedene Schritte durchgeführt. Zunächst erfolgt eine Bereitstellung eines Lithografiefluids, welches derart auf die Laserstrahlquelle abgestimmt ist, dass die Verfestigung nur in dem Fokusbereich und nur unter Ausnutzung eines Zwei-Photonen-Prozesses bzw. allgemeiner eines Multi-Photonen-Prozesses erfolgen kann. Danach erfolgt ein Zuführen des Lithografiefluids durch den Fluidzugang in den Fluidraum. Die Verwendung umfasst dann den Schritt eines Applizierens eines Volumens an Lithografiefluid durch den Austrittsspalt. Das Applizieren ist hierbei als ein Ausbringen von Lithografiefluid durch den Austrittsspalt in einen außerhalb liegenden Raumbereich zu verstehen. Insbesondere wird das Volumen an Lithografiefluid auf das Substrat oder auf ein bereits vorhandenes Volumen an Lithografiefluid ausgebracht. Schließlich erfolgt ein Einbringen des Schreibstrahls, bzw. konkreter des Fokusbereichs des Schreibstrahls durch das Objektiv in das Volumen an Lithografiefluid. Dadurch erfolgt eine lokale Verfestigung des Lithografiefluids in dem Fokusbereich durch einen Zwei-Photonen-Prozess oder allgemeiner einen Multi-Photonen-Prozess (Beteiligung von zwei oder mehr Photonen gleichzeitig). Auf diese Weise kann eine dreidimensionale Struktur innerhalb des Lithografiefluids geschrieben werden.

Durch diese Art der Verwendung eines Dispenser-Aufsatzes wird die Laserlithografie-Vorrichtung derart erweitert und verbessert, dass kontinuierlich Strukturen erzeugt werden können. Insbesondere ist es möglich, hohe Strukturen und/oder Strukturen mit großen Profiltiefen bezüglich der Richtung des Einbringens des Schreibstrahles zu erzeugen. Dies kann dadurch erfolgen, dass das Objektiv oder ein Druckkopf der Lithografie-Vorrichtung mit dem Objektiv von der Substratoberfläche weg bewegt wird und kontinuierlich Lithografiefluid durch den Austrittsspalt nachgeliefert wird.

Die beschriebene Verwendung bietet z.B. den Vorteil, dass nach dem Schreiben einer Struktur auf einem Substrat dieses entfernt werden kann und ein neues Substrat bereitgestellt werden kann. Insbesondere ist es nicht erforderlich, auf dem Substrat vor dem Beschreiben mit einer Struktur eine Schicht oder ein Volumen an Lithografiefluid aufzutragen. Insofern können Vorbehandlungsschritte reduziert und vereinfacht werden. Dadurch wird mit den Laserlithografie-Vorrichtungen der genannten Art ein Produktionsprozess mit hoher Durchsatzrate ermöglicht.

Das Lithografiefluid kann bei dem beschriebenen Vorgehen in einem separaten Reservoir aufbewahrt werden, welches mit einer Fluidleitung mit dem Fluidraum verbunden ist. Gegebenenfalls kann eine Fluidpumpe vorgesehen sein, welche das Fluid aus dem Reservoir in den Fluidraum pumpt. Dadurch wird eine Exposition des Lithografiefluids an der Umgebungsatmosphäre weitgehend vermieden. Dadurch können Verschmutzungen des Lithografiefluids und eine unerwünschte Degradation des Lithografiefluids reduziert werden. Dies begünstigt die Qualität der geschriebenen Strukturen.

Bei der beanspruchten Verwendung ist es insbesondere möglich, auch Mikroskopie-Objektive einzusetzen, wie sie als Standardbauteile für Mikroskope verfügbar sind. Insbesondere kann dann ein Dispenser-Aufsatz verwendet werden, wie er im Bereich der Mikroskopie zur Applikation von Immersionsöl mit dem Ziel der Verbesserung von optischen Eigenschaften zum Einsatz kommt. Die Erfindung betrifft insofern die Verwendung eines Dispensers der genannten Art zum Zwecke der Applikation von Lithografiefluid.

Nach einem grundsätzlichen Aspekt wird der Fokusbereich insbesondere in dem Bereich zwischen einer Oberfläche des Substrats und der Abschlusslinse des Objektivs positioniert.

Nach einer vorteilhaften Ausgestaltung erfolgt der Schritt des Applizierens von Lithografiefluid derart, dass das Lithografiefluid in Kontakt mit der Abschlusslinse verbleibt und der Schreibstrahl in das Lithografiefluid eingebracht wird, während es noch in Kontakt mit der Abschlusslinse steht. Insofern wird der Fokusbereich in ein die Abschlusslinse berührendes Volumen an Lithografiefluid eingebracht. Da die lokale Verfestigung des Lithografiefluids in dem Fokusbereich nur unter Ausnutzung eines Zwei-Photonen-Prozesses oder allgemeiner eines Multi-Photonen-Prozesses erfolgt, findet die Verfestigung in dem Fokusbereich beabstandet von der Abschlusslinse statt und nicht unmittelbar in dem Bereich des Lithografiefluid-Volumens, welches an der Abschlusslinse anhaftet. Dadurch wird vermieden, dass die Abschlusslinse durch verfestigtes Lithografiefluid verklebt. Da das Lithografiefluid direkt an der Abschlusslinse anhaftet, wird eine optische Grenzfläche im Strahlengang zwischen Abschlusslinse und Fokusbereich vermieden (wie dies z.B. bei einem Übergang zwischen Luft und Lithografiefluid oder Linse und Luft auftreten würde). Dadurch können Abbildungsfehler vermindert werden, welche zu Qualitätseinbußen und Ungenauigkeiten in der geschriebenen Struktur führen können). Durch das beschriebene Vorgehen wird das Lithografiefluid in situ zur Verfügung gestellt. Die Schritte applizieren und Schreiben der Struktur können unterbrechungsfrei nacheinander ausgeführt werden. Um ausgedehnte Strukturen zu schreiben, kann beispielsweise zunächst ein Tropfen von Lithografiefluid appliziert werden, dann in den Tropfen geschrieben werden, und dann Lithografiefluid nachgeliefert werden und so mehr Raum für weitere Strukturabschnitte geschaffen werden.

Vorteilhaft kann es sein, wenn der Schritt des Applizierens derart erfolgt, dass das Lithografiefluid einerseits mit dem Substrat und andererseits mit der Abschlusslinse in Kontakt verbleibt und der Schreibstrahl in das Lithografiefluid eingebracht wird, während das Lithografiefluid in Kontakt mit der Abschlusslinse und dem Substrat ist. Insofern füllt das Lithografiefluid insbesondere den Zwischenraum zwischen Abschlusslinse und Substrat aus. Zwischen Abschlusslinse und Substrat bildet sich insofern ein zusammenhängender Tropfen, welcher das Flüssigkeitsvolumen und die darin geschriebenen Strukturen stabilisiert. Auch hierbei wird ein kontinuierliches Schreiben großer Strukturen ermöglicht, indem das Objektiv kontinuierlich vom Substrat weg bewegt wird und kontinuierlich Lithografiefluid nachgeliefert wird. Insbesondere kann verhindert werden, dass der Tropfen von Lithografiefluid vom Objektiv abreißt.

Eine vorteilhafte Weiterbildung der Verwendung besteht darin, dass ein erstes Lithografiefluid bereitgestellt und durch den Fluidraum und den Austrittsspalt appliziert wird, und danach - gegebenenfalls unter Zwischenschaltung weiterer Schritte - ein zweites Lithografiefluid bereitgestellt und durch den Fluidraum und den Austrittsspalt appliziert wird. Hierbei ist insbesondere denkbar, dass das erste Lithografiefluid und das zweite Lithografiefluid verschiedene Materialien mit insbesondere verschiedenen Materialeigenschaften sind. Insbesondere kann dann nach dem Applizieren des ersten Lithografiefluids und vor dem Applizieren des zweiten Lithografiefluids mit dem Schreibstrahl zunächst eine erste Struktur in dem Lithografiefluid geschrieben werden. Danach kann das zweite Lithografiefluid appliziert werden und eine zweite Teilstruktur geschrieben werden. Insofern können bei diesem Vorgehen Multi-Materialstrukturen hergestellt werden.

Vorteilhaft kann es jedoch auch sein, dass zunächst die beiden verschiedenen Lithografiefluide nacheinander appliziert werden und miteinander vermischt werden. Das Einbringen des Schreibstrahles erfolgt dann vorzugsweise in ein Volumen aus vermischtem erstem Lithografiefluid und zweitem Lithografiefluid. Das beschriebene Vorgehen ermöglicht somit, Materialeigenschaften gezielt anzupassen, beispielsweise durch unterschiedliche Mischverhältnisse. Das Vermischen der beiden Lithografiefluide kann auf verschiedene Weisen erfolgen, beispielsweise durch einen intrinsischen Diffusionsprozess oder unter Zuhilfenahme durch Hilfsmittel zum Vermischen (beispielsweise Druckluftstrahl).

Zur weiteren Ausgestaltung erfolgt nach dem Schritt des Einbringens des Schreibstrahls und insbesondere des Fokusbereichs und nach der lokalen Verfestigung des Lithografiefluids ein Bereitstellen eines Entwicklerfluids und ein Zuführen des Entwicklerfluids durch den Fluidzugang in den Fluidraum. Das Entwicklerfluid ist insbesondere dazu ausgebildet, die geschriebene dreidimensionale Struktur freizulegen und/oder zu Härten. Beispielsweise kann das Entwicklerfluid ein Lösungsmittel sein, welches derart auf das Lithografiefluid abgestimmt ist, das nur nicht verfestigtes Lithografiefluid gelöst wird und verfestigtes Lithografiefluid zurück bleibt. Durch ein Applizieren eines Volumens des Entwicklerfluids durch den Austrittsspalt können die geschriebenen Strukturen in situ freigelegt werden.

Das beschriebene Vorgehen kann dadurch weiter ausgestaltet werden, dass in den Fluidraum ein Druckgas zugeführt wird. Insbesondere kann dann ein Schritt vorgesehen sein, bei dem das Druckgas durch den Austrittsspalt austritt. Dieser Schritt kann zu verschiedenen Zeitpunkten vorgesehen sein, beispielsweise vor dem ersten Applizieren von Lithografiefluid. In diesem Fall können beispielsweise Verunreinigungen von dem Substrat entfernt werden. Denkbar ist jedoch auch, dass das Druckgas nach dem Applizieren eines Volumens an Lithografiefluid durch den Austrittsspalt austritt, um das Lithografiefluid auf dem Substrat zu verteilen oder zu verdrängen. Denkbar ist auch, nach einem Applizieren von zwei verschiedenen Lithografiefluiden (siehe oben) die beiden Lithografiefluide durch austretendes Druckgas zu vermischen. Als Druckgas kann beispielsweise Druckluft oder ein Inertgas eingesetzt werden.

Zur weiteren Ausgestaltung kann ein Reinigungsfluid bereitgestellt und dem Fluidraum zugeführt werden, sowie gegebenenfalls durch den Austrittsspalt ausgestoßen werden. Das Reinigungsfluid ist insbesondere derart ausgebildet, dass sowohl unverfestigtes (flüssiges) und verfestigtes Lithografiefluid aufgelöst wird. Das Ausstoßen des Reinigungsfluids durch den Austrittsspalt erfolgt insbesondere derart, dass die Abschlusslinse mit dem Reinigungsfluid benetzt wird. Durch dieses Vorgehen wird eine in situ Reinigung ermöglicht, insbesondere im Sinne einer automatisierten Reinigungsprozedur. Dies erfolgt vorzugsweise nach dem Schreiben einer Struktur und/oder vor dem Austausch von Substraten. Dadurch werden Prozessdauern verkürzt, da die Reinigungsprozeduren vereinfacht und verkürzt werden können.

Der Fluidraum kann zur Erzeugung weiterer Funktionalitäten genutzt werden. Beispielsweise kann in den Fluidraum Licht eingebracht werden, z.B. mittels eines in den Fluidraum einmündenden Lichtleiters. Das Licht tritt dann, je nach Ausgestaltung, durch den Austrittsspalt aus und kann dazu eingesetzt werden, dass das Substrat und/oder ein bereits appliziertes Volumen an Lithografiefluid und/oder eine bereits geschriebene dreidimensionale Struktur zu beleuchten. Dies ist vorteilhaft, da bei den Verfahren zum direkten Laserschreiben in der Regel eine in situ Bildüberwachung der geschriebenen Struktur wünschenswert ist. Dabei ist weiterhin denkbar, dass mittels des zum Schreiben verwendeten Objektivs auch ein Bild der beleuchteten Struktur und/oder des Substrats aufgenommen wird. Das Einbringen von Licht kann beispielsweise nach dem Zuführen des Lithografiefluids durch den Fluidzugang in den Fluidraum erfolgen. In diesem Fall kann das Lithografiefluid zur Lichtleitung aus dem Fluidraum durch den Austrittsspalt beitragen. Das Eindringen von Licht kann beispielsweise durch den Fluidzugang oder durch einen separaten Zugang hindurch in den Fluidraum erfolgen.

Als Objektiv kann grundsätzlich ein Immersionsobjektiv verwendet werden. Solche Immersionsobjektive sind beispielsweise als Zubehör in der Mikroskopie bekannt und dienen dort zur Erzielung besserer Abbildungsqualitäten. Insbesondere wird ein Immersionsobjektiv verwendet, welches eine Konfiguration aufweist, die an die Brechzahl des verwendeten Lithografiefluids angepasst ist.

Ein vorteilhafter Dispenser-Aufsatz bzw. ein vorteilhaftes System aus einem Dispenser-Aufsatz und einem Objektiv weist ein insbesondere kappenartiges Gehäuse auf, welches dazu ausgebildet ist, auf das Objektiv bzw. das Objektivgehäuse derart aufgesetzt zu werden, dass ein Fluidraum gebildet wird und ein Austrittsspalt zwischen Dispenser-Gehäuse und Abschlusslinse des Objektivs gebildet wird. Ferner weist ein Dispenser-Aufsatz einen Fluidzugang zum Zuführen von Fluiden in den Fluidraum auf. Ein besonders geeigneter Dispenser-Aufsatz ergibt sich dadurch, dass das Dispenser-Gehäuse derart an das Objektiv angepasst ist, dass der Austrittsspalt ein Ringspalt um die Abschlusslinse ist, wobei der Ringspalt von einem umlaufenden Rand des Dispenser-Gehäuses derart begrenzt ist, dass die Abschlusslinse über das Dispenser-Gehäuse hervorragt. Insbesondere überragt die Abschlusslinse das Dispenser-Gehäuse in Strahlrichtung des Schreibstrahls. Dadurch wird bei einer Verwendung gemäß der vorstehenden Beschreibung vermieden, dass bereits geschriebene Strukturen beim Verlagern des Objektivs an das Dispenser-Gehäuse anstoßen und dadurch beschädigt werden.

Ein für die beschriebene Verwendung besonders geeigneter Dispenser-Aufsatz bzw. ein besonders geeignetes System aus einem Dispenser-Aufsatz und einem Objektiv ergibt sich auch dadurch, dass das Dispenser-Gehäuse eine Innenwandung und eine die Innenwandung umlaufende Außenwandung aufweist, so dass die Innenwandung dem Objektivgehäuse zugewandt ist und dass der Fluidraum zwischen der Innenwandung und der Außenwandung gebildet ist. Vorzugsweise weist dann die Innenwandung ein Durchstrahlfenster aus einem fluiddichten und optisch transparentem Material auf, welches der Abschlusslinse zugewandt ist. Insbesondere ist das Durchstrahlfenster der Abschlusslinse in Strahlrichtung gegenüberliegend positioniert. Der Austrittsspalt wird vorzugsweise zwischen dem Austrittsfenster und der Außenwandung gebildet. Insofern weist ein solcher Dispenser-Aufsatz ein doppelwandiges Dispenser-Gehäuse auf und das Fluid ist zwischen Innenwandung und Außenwandung geführt. Mittels des Durchstrahlfensters wird vermieden, dass die Abschlusslinse in direktem Kontakt mit dem Lithografiefluid gerät. Durch die Innenwandung wird ebenfalls vermieden, dass das Objektivgehäuse und/oder optische Bauteile des Objektivs in Kontakt mit dem Lithografiefluid kommen. Dadurch werden Verunreinigungen vermieden. Außerdem ermöglicht die genannte Ausgestaltung eine Verwendung von Standard-Luftobjektiven. Innenwandung und Außenwandung sind vorzugsweise als im Wesentlichen kreiszylindrische Wandungen ausgebildet. Vorzugsweise umläuft die Außenwandung die Innenwandung koaxial. Der Strahlengang durch Objektiv und Dispenser-Aufsatz ist vorzugsweise konzentrisch durch diese Wandungen hindurch.

Ein vorteilhaft verwendbarer Dispenser-Aufsatz bzw. ein vorteilhaft verwendbares System aus einem Dispenser-Aufsatz und einem Objektiv ergibt sich auch dadurch, dass das Dispenser-Gehäuse wenigstens einen zusätzlichen Zugang in den Fluidraum aufweist. Der zusätzliche Zugang ist insbesondere von dem Fluidzugang separat ausgebildet. Durch diesen Zugang können zusätzliche Funktionen in den Fluidraum eingebracht werden. Beispielsweise kann der Zugang zur Zuleitung von Fluiden (z.B. Druckfluid) oder unterschiedliche Lithografiefluide) oder zur Zuleitung von Licht in den Fluidraum ausgebildet sein. Dabei kann der Zugang einen Lichtleiter umfassen, mittels welchem Licht einer vorzugsweise externen Lichtquelle in den Fluidraum eingeleitet werden kann.

Die Erfindung wird im Folgenden anhand der Figuren näher erläutert.

Es zeigen:
Figur 1 schematische Darstellung einer Vorrichtung zum Schreiben von Strukturen mittels Laserlithografie in einem Lithografiefluid;
Figur 2 skizzierte Darstellung eines Dispenser-Aufsatzes zur Verwendung in einer Vorrichtung gemäß Figur 1;
Figur 3 skizzierte Darstellung zur Erläuterung weiterer Ausgestaltungsmöglichkeiten eines Dispenser-Aufsatzes zur Verwendung in einer Vorrichtung gemäß Figur 1; und
Figur 4 skizzierte Darstellung zur Erläuterung weiterer Ausgestaltungsmöglichkeiten für einen Dispenser-Aufsatz zur Verwendung in einer Vorrichtung gemäß Figur 1.

In der nachfolgenden Beschreibung sowie in den Figuren sind für identische oder einander entsprechende Merkmale jeweils dieselben Bezugszeichen verwendet.

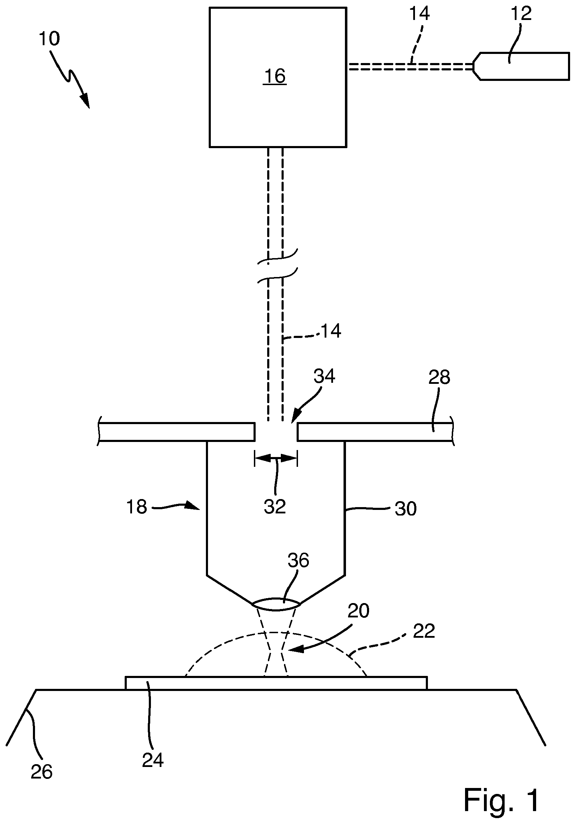

Die Figur 1 zeigt in skizzierter Darstellung eine Vorrichtung 10 zum Schreiben von dreidimensionalen Strukturen mittels Laserlithografie in einem Lithografiefluid, kurz als Laserlithografie-Vorrichtung 10 bezeichnet. Die Vorrichtung 10 umfasst eine Laserstrahlquelle 12 zur Abgabe eines Schreibstrahls 14 aus Laserlicht. Der Schreibstrahl 14 durchläuft je nach Ausgestaltung beispielsweise eine Strahlführungs- und Lenkungseinrichtung 16, welche aus dem von der Laserstrahlquelle 12 abgegebenen Licht einen für die Zwecke der Laserlithografie geeigneten Schreibstrahl formt und beispielsweise den Schreibstrahl entsprechend von Geometriebeschreibungsdaten einer gewünschten Struktur auslenkt bzw. bewegt. Hierzu kann die Strahlführungs- und Lenkungseinrichtung 16 mit einer nicht dargestellten Steuerungseinrichtung zusammenwirken.

Der Schreibstrahl 14 wird mittels eines Objektivs 18 in einen Ausgangsstrahl mit einem Fokusbereich 20 umgeformt. Der Fokusbereich 20 ist insbesondere in der Art einer Strahltaille des Schreibstrahls 14 ausgebildet.

Zum Schreiben einer dreidimensionalen Struktur wird der Fokusbereich 20 in ein Volumens an Lithografiefluid 22 eingebracht und ggf. in dem Volumen gemäß der Geometriebeschreibungsdaten für die gewünschte Struktur bewegt. Im Fokusbereich 20 löst der Schreibstrahl 14 in dem Lithografiefluid 22 eine Verfestigungsreaktion aus. Damit die Verfestigungsreaktion auch innerhalb des Volumens des Lithografiefluids 22, also unterhalb einer Oberfläche des Lithografiefluids 22 erfolgen kann, ist für die Zwecke der vorliegenden Erfindung das Lithografiefluid 22 derart auf den Schreibstrahl 14 abgestimmt, dass die Verfestigung nur im Fokusbereich 20 und nur unter Ausnutzung von Multi-Photonen-Absorptionsprozessen erfolgen kann.

Im dargestellten Beispiel ist das Volumen an Lithografiefluid 22 auf einem Substrat 24 tropfenartig aufgebracht. Dies ist jedoch nicht zwingend. Das Volumen an Lithografiefluid 22 kann auch in einem Behälter bereitgestellt werden oder, wie nachfolgend erläutert, in der Art eines Tropfens bereitgestellt werden, welcher mit dem Objektiv 18 in Kontakt ist. Das Substrat 24 kann auf einem Substrathalter 26 fixiert sein, welcher beispielsweise in einer Schreibebene verlagerbar ausgestaltet ist.

Das Objektiv 18 kann beispielsweise an einer Kopfplatte 28 der Vorrichtung 10 montiert sein. Denkbar ist, dass die Kopfplatte 28 ebenfalls mit entsprechenden Aktuatoren geringfügig verlagerbar ausgestaltet ist.

Insgesamt ermöglicht die Konstruktion der Vorrichtung 12, den Fokusbereich 20 in drei Raumrichtungen innerhalb des Volumens an Lithografiefluid 22 zu verlagern.

Das Objektiv 18 umfasst ein Objektivgehäuse 30, welches vorzugsweise derart an der Kopfplatte 28 montiert ist, dass eine Eintrittsappertur 32 des Objektivs 18 mit einer entsprechenden Öffnung 34 der Kopfplatte 28 korrespondiert. Durch die Öffnung 34 und die Eintrittsapertur 32 wird der Schreibstrahl 14 in einer Strahlrichtung durchgestrahlt. Das Objektiv 18 umfasst außerdem eine Abschlusslinse 36, durch welche der Schreibstrahl 14 austritt und den Fokusbereich 20 bildet.

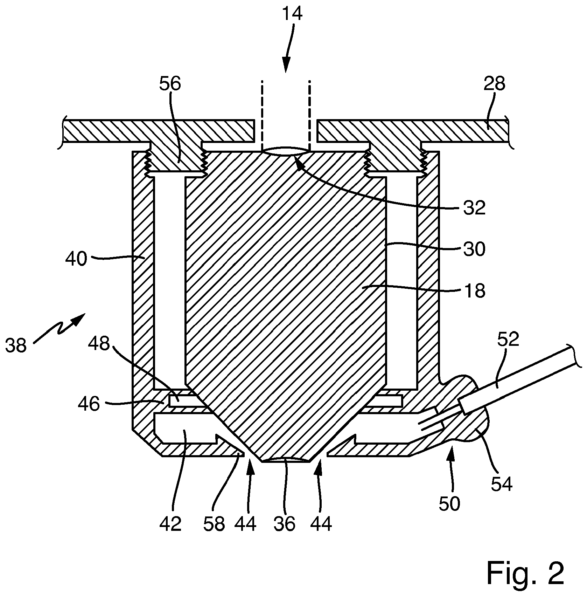

Die Verwendung eines Dispenser-Aufsatzes 38 in einer Vorrichtung nach der Art von Figur 1 wird anhand der Figuren 2 bis 4 exemplarisch erläutert. Diese Figuren zeigen jeweils exemplarisch einen Ausschnitt aus einer Vorrichtung 10 der in Figur 1 gezeigten Art mit Detailansicht im Bereich der Kopfplatte 28 und des Objektivs 18.

Die Figur 2 zeigt einen Dispenser-Aufsatz 38 mit einem Dispenser-Gehäuse 40, welches auf das Objektiv 18 aufgesetzt werden kann und zwar derart, dass das Dispenser-Gehäuse 40 das Objektiv 18 zumindest bereichsweise umgibt. Dadurch wird von dem Dispenser-Gehäuse 40 oder von dem Dispenser-Gehäuse zusammen mit Wandungsbereichen des Objektivgehäuses 30 ein Fluidraum 42 begrenzt. Das Dispenser-Gehäuse 40 weist eine nach unten (d.h. von der Kopfplatte 28 weg weisende) Öffnung derart auf, dass mit dem Objektiv 18 ein Austrittsspalt 44 gebildet ist. Der Austrittsspalt 44 ist vorzugsweise derart ausgebildet, dass er die Abschlusslinse 36 insbesondere ringartig umläuft. Vorzugsweise grenzt der Austrittsspalt 44 unmittelbar an einen Rand der Abschlusslinse 36 an. Der Fluidraum 42 mündet insofern durch den Austrittsspalt 44 in die Umgebung.

Vorzugsweise ist das Volumen des Fluidraums 42 im Innern des Dispenser-Gehäuses 40 dadurch begrenzt und abgedichtet, dass ein Dichtvorsprung 46 von Wandungen des Dispenser-Gehäuses 40 nach radial innen weist und zwar derart, dass beim Aufsetzen des Dispenser-Gehäuses 40 auf das Objektiv 18 der Dichtvorsprung 46 an dem Objektivgehäuse 30 anliegt und dadurch den Fluidraum 42 abdichtet. In dem Dichtvorsprung 46 kann beispielsweise eine entsprechende Ringdichtung 48 zur Verbesserung der Dichtheit angeordnet sein.

Der Dispenser-Aufsatz 38 umfasst außerdem einen Fluidzugang 50 zum Zuführen von Fluid in den Fluidraum 42. Hierzu kann beispielsweise eine Fluidleitung 52 durch einen entsprechenden Dichtabschnitt 54 am Dispenser-Gehäuse 40 hindurchgeführt sein und in den Fluidraum 42 einmünden. Vorzugsweise bilden Objektiv 18 und Dispenser-Aufsatz 38 ein aufeinander abgestimmtes System. Insbesondere sind Objektiv 18 und Dispenser-Aufsatz 38 mit aufeinander abgestimmten Montagemitteln an einem Druckkopf der Vorrichtung 10 montiert. Wie in Figur 2 skizziert, kann beispielsweise die Kopfplatte 28 einen Doppelgewinde-Ring 56 aufweisen, wobei an einem Innengewinde des Doppelgewinde-Rings 56 das Objektivgehäuse 30 eingeschraubt wird, und an dem gegenüberliegenden Außengewinde des Doppelgewinde-Rings 56 das Dispenser-Gehäuse 40 angeschraubt wird.

Das Objektiv 18 und der Dispenser-Aufsatz 38 sind gemäß einem vorteilhaften Aspekt derart aufeinander abgestimmt, dass die Abschlusslinse 36 des Objektivs 18 das Dispenser-Gehäuse 40 im Bereich eines umlaufenden Randes 58 in Richtung der Fortpflanzung des Schreibstrahls 14 überragt (vgl. Figur 2).

Die Verwendung des Dispenser-Aufsatzes mit dem Objektiv 18 in der Vorrichtung 10 erfolgt dann dadurch, dass zunächst ein Lithografiefluid 22 bereitgestellt wird und dem Fluidraum 42 durch den Fluidzugang 50 hindurch zugeführt wird. Nach einem allgemeinen Aspekt kann vorgesehen sein, dass die Zuführung des Lithografiefluids durch den Fluidzugang 50 mit einem entsprechenden Druck erfolgt, so dass sich das Lithografiefluid möglichst gleichmäßig in dem Fluidraum 42 verteilt und in Richtung des Austrittsspaltes 44 aus dem Fluidraum 42 hinausgedrückt wird. Dies ermöglicht ein Applizieren eines Volumens an Lithografiefluid durch den Austrittspalt 44, beispielsweise in der Art eines Tropfens auf dem Substrat 24 (vgl. Figur 1). Denkbar ist auch, dass ein Volumen an Lithografiefluid 22 an der Abschlusslinse 36 des Objektivs 18 anhaftet, nachdem das Lithografiefluid 22 durch den Austrittsspalt 44 ausgetreten ist. Ebenso kann vorteilhaft sein, wenn so viel Lithografiefluid 22 ausgebracht wird, dass das es einen Zwischenraum zwischen der Abschlusslinse 36 und dem Substrat 24 ausfüllt. Insofern kann bei geeigneter Ausgestaltung des Objektivs 18 die Abschlusslinse 38 in das applizierte Volumen an Lithografiefluid 22 eintauchen (in der Art einer Immersionsobjektivs).

Danach kann durch Erzeugung des Schreibstrahls mit dem Fokusbereich 20 in der zu Figur 1 erläuterten Art und Weise die gewünschte Struktur geschrieben werden. Bei Bedarf kann dann weiteres Lithografiefluid 22 nachgeliefert werden, nämlich durch Zuführen von Lithografiefluid 22 durch den Fluidzugang 50 hindurch in den Fluidraum 42 hinein und durch den Austrittspalt 44 hindurch.

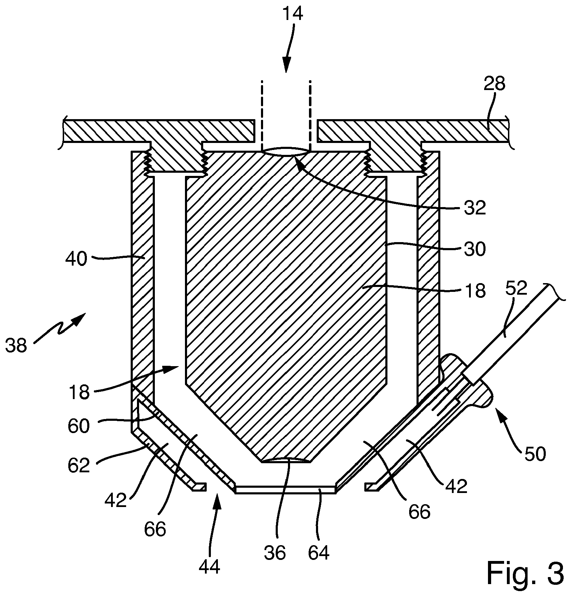

Eine weitere vorteilhafte Verwendung eines Dispenser-Aufsatzes 38 ist mit der in Figur 3 gezeigten Ausgestaltung möglich. Demzufolge kann der Dispenser-Aufsatz 38 doppelwandig ausgestaltet sein und insofern eine Innenwandung 60 und eine konzentrisch hierum verlaufende Außenwandung 62 aufweisen. Dadurch wird zwischen Innenwandung 60 und Außenwandung 62 der Fluidraum 42 gebildet. Vorzugsweise umlaufen sowohl Innenwandung 60 als auch Außenwandung 62 das Objektivgehäuse 30 koaxial, beispielsweise in der Art von kreiszylindrischen Mantelflächen.

Zur weiteren Ausgestaltung kann die dem Objektiv 18 zugewandte Innenwandung 60 ein Durchstrahlfenster 64 aufweisen, welches im montierten Zustand des Dispenser-Aufsatzes 38 der Abschlusslinse 36 zugewandt ist, so dass der durch die Abschlusslinse 36 austretende Schreibstrahl 14 durch das Durchstrahlfenster 64 hindurch austritt. Insbesondere sind Innenwandung 60 und Durchstrahlfenster 64 derart ausgebildet, dass um das Objektivgehäuse 30 und die Abschlusslinse 36 herum ein abgeschlossener Luftraum 66 gebildet wird, welcher durch die Innenwandung 60 und/oder das Durchstrahlfenster 64 von dem Fluidraum 42 abgetrennt ist.

Bei der Verwendung dieses Dispenser-Aufsatzes 38 wird Lithografiefluid 22 durch den Fluidzugang 50 in den Fluidraum 42 zugeführt und gelangt nicht mit der Abschlusslinse 36 des Objektivs 18 in Kontakt. Vorzugsweise wird der Austrittsspalt 44 dann zwischen Durchstrahlfenster 64 und Außenwandung 62 des Dispenser-Aufsatzes 38 gebildet.

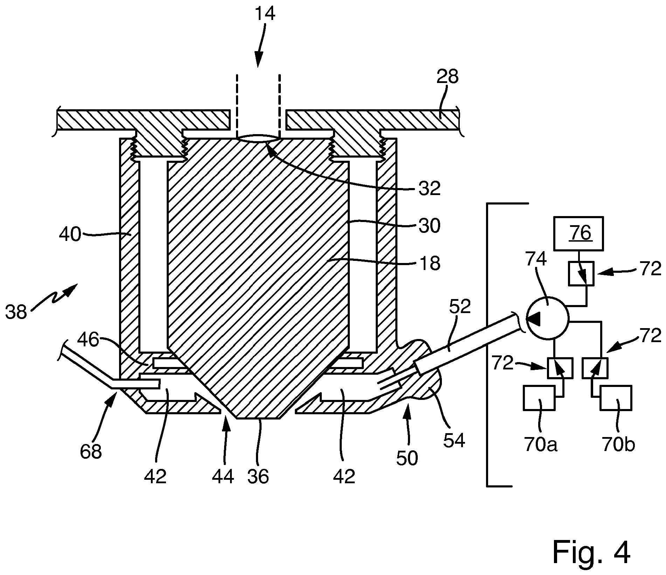

Die Verwendung des Dispenser-Aufsatzes 38 ermöglicht verschiedene Zusatzfunktionen (vgl. Figur 4). Hierzu kann das Dispenser-Gehäuse 40 derart ausgestaltet sein, dass ein zusätzlicher Zugang 68 in den Fluidraum 42 bereitgestellt wird. Durch den zusätzlichen Zugang 68 kann beispielsweise ein nicht näher dargestellter Lichtleiter geführt sein, mittels welchem Licht in den Fluidraum 42 eingebracht werden kann, beispielsweise um den Raumbereich vor der Abschlusslinse 36 zu beleuchten. Denkbar ist auch, dass durch den zusätzlichen Zugang 68 Druckgas oder sonstige Fluide in den Fluidraum 42 eingebracht werden, wie vorstehend beschrieben.

Eine vorteilhafte Verwendung des Dispenser-Aufsatzes 38 ergibt sich dadurch, dass durch den Fluidzugang 50 nacheinander verschiedene Lithografiefluide mit insbesondere unterschiedlichen Materialeigenschaften in den Fluidraum 42 zugeführt werden (vgl. Figur 4). Verschiedene Lithografiefluide 22 können hierzu in jeweils separaten Fluidreservoirs 70a, 70b bereitgestellt werden. Über entsprechende Schaltventile 72 kann dann wahlweise Fluid aus dem Reservoir 70a oder 70b (beispielsweise mittels einer Fluidpumpe 74) durch die Fluidleitung 52 in den Fluidraum 42 befördert werden. Zur weiteren Ausgestaltung ist auch denkbar, dass in wenigstens einem weiteren Reservoir 76 ein Entwicklerfluid oder ein Reinigungsfluid bereitgestellt wird, welches wiederum wahlweise über ein Schaltventil 72 und ggf. über eine Fluidpumpe 74 dem Fluidraum 42 zugeführt werden kann.

Die Verwendung der in den Figuren 2 bis 4 skizzierten Dispenser-Aufsätzen erfolgt grundsätzliche gemäß den eingangs beschriebenen Verwendungsschritten.

## Patentansprüche

1. Verwendung eines Dispenser-Aufsatzes (38), insbesondere eines Dispenser-Aufsatzes (38) für Mikroskopie-Objektive, in einer Vorrichtung (10) zum Schreiben von dreidimensionalen Strukturen mittels Laserlithografie in einem Lithografiefluid (22), welches durch Bestrahlung mit Laserlicht verfestigbar ist,
die Vorrichtung (10) umfassend:
- eine Laserstrahlquelle (12) zur Abgabe eines Schreibstrahls (14);
- ein Substrat (24) zur Aufnahme von Lithografiefluid (22),
- ein Objektiv (18) zum Ausbilden eines Fokusbereichs (20) des Schreibstrahls (14) in dem Lithografiefluid (22), das Objektiv (18) umfassend ein Objektivgehäuse (30) und eine Abschlusslinse (36);
der Dispenser-Aufsatz (38) umfassend:
- ein Dispenser-Gehäuse (40), welches dazu ausgebildet ist, auf das Objektiv (18) derart aufgesetzt zu werden, dass ein Fluidraum (42) zwischen Objektivgehäuse (30) und Dispenser-Gehäuse (40) gebildet wird und dass ein Austrittsspalt (44) zwischen Dispenser-Gehäuse (40) und Abschlusslinse (36) gebildet wird,
- und einen Fluidzugang (50) in den Fluidraum (42);
wobei für die Verwendung folgende Schritte durchgeführt werden:
- Bereitstellung eines Lithografiefluids (22), welches derart auf die Laserstrahlquelle (12) abgestimmt ist, dass die Verfestigung nur in dem Fokusbereich (20) und unter Ausnutzung eines Multi-Photonen-Prozesses erfolgt;
- Zuführen des Lithografiefluids (22) durch den Fluidzugang (50) in den Fluidraum (42);
- Applizieren eines Volumens an Lithografiefluid (22)
durch den Austrittsspalt (44);
- Einbringen des Schreibstrahls (14) durch das Objektiv (18) in das Volumen an Lithografiefluid (22) und lokale Verfestigung des Lithografiefluids (22) in dem Fokusbereich (20) durch einen Multi-Photonen-Prozesse zum Schreiben der dreidimensionalen Struktur.

2. Verwendung nach Anspruch 1, wobei der Schritt des Applizierens derart erfolgt, dass das Lithografiefluid (22) in Kontakt mit der Abschlusslinse (36) verbleibt und der Schreibstrahl (14) in das Lithografiefluid (22) eingebracht wird, während das Lithografiefluid (22) in Kontakt mit der Abschlusslinse (36) ist.

3. Verwendung nach Anspruch 1 oder 2, wobei der Schritt des Applizierens derart erfolgt, dass das Lithografiefluid (22) einerseits mit dem Substrat (24) und andererseits mit der Abschlusslinse (36) in Kontakt verbleibt.

4. Verwendung nach einem der vorherigen Ansprüche, wobei ein erstes Lithografiefluid (22) bereitgestellt wird, durch den Fluidzugang (50) in den Fluidraum (42) zugeführt wird und ein erstes Volumen des ersten Lithografiefluids (22) durch den Austrittsspalt (44) appliziert wird,
und wobei danach ein zweites Lithografiefluid (22) bereitgestellt wird, durch den Fluidzugang (50) in den Fluidraum (42) zugeführt wird und ein zweites Volumen des zweiten Lithografiefluids (22) durch den Austrittsspalt (44) appliziert wird.

5. Verwendung nach Anspruch 4, wobei das erste Lithografiefluid (22) und das zweite Lithografiefluid (22) verschiedene Materialien mit verschiedenen Materialeigenschaften sind.

6. Verwendung nach Anspruch 4 oder 5, wobei nach dem Applizieren des ersten Lithografiefluids (22) und vor dem Applizieren des zweiten Lithografiefluids (22) wenigstens ein Schritt des Einbringens des Schreibstrahls (14) in das Volumen an erstem Lithografiefluid (22) und lokale Verfestigung des ersten Lithografiefluids (22) erfolgt.

7. Verwendung nach Anspruch 4 oder 5, wobei zunächst das erste Lithografiefluid (22) appliziert wird und dann das zweite Lithografiefluid (22) appliziert wird, und dann das erste Lithografiefluid und das zweite Lithografiefluid vermischt werden.

8. Verwendung nach einem der vorherigen Ansprüche, wobei nach dem Schritt des Einbringens des Schreibstrahls (14) und der lokalen Verfestigung des Lithografiefluids (22) folgende Schritte durchgeführt werden:
- Bereitstellung eines Entwicklerfluids zur Freilegung und/oder Härtung der geschriebenen dreidimensionalen Struktur;
- Zuführen des Entwicklerfluids durch den Fluidzugang (50) in den Fluidraum (42);
- Applizieren eines Volumens an Entwicklerfluids durch den Austrittsspalt.

9. Verwendung nach einem der vorherigen Ansprüche, umfassend den folgenden Schritt:
- Bereitstellen und Zuführen von Druckgas durch den Fluidzugang (50) oder durch einen zusätzlichen Zugang (68) in den Fluidraum (42).

10. Verwendung nach einem der vorherigen Ansprüche, umfassend den folgenden Schritt:
- Bereitstellen von Reinigungsfluid, welches dazu ausgebildet ist, unverfestigtes und verfestigtes Lithografiefluid (22) aufzulösen;
- Zuführen des Reinigungsfluids durch den Fluidzugang (50) oder durch einen zusätzlichen Zugang (68) in den Fluidraum (42);
- Ausstoßen von Reinigungsfluid durch den Austrittsspalt (44).

11. Verwendung nach einem der vorherigen Ansprüche, umfassend den folgenden Schritt:
- Einbringen von Licht in den Fluidraum (42), insbesondere mittels eines in den Fluidraum (42) einmündenden Lichtleiters.

12. Verwendung nach einem der vorherigen Ansprüche, wobei als Objektiv (18) ein Immersionsobjektiv eingesetzt wird.

13. Verwendung nach einem der vorherigen Ansprüche,
**dadurch gekennzeichnet, dass** das Dispenser-Gehäuse (40) derart ausgebildet ist, dass der Austrittsspalt (44) ein Ringspalt um die Abschlusslinse (36) ist, wobei der Ringspalt von einem umlaufenden Rand (58) des Dispenser-Gehäuses (40) derart begrenzt ist, dass die Abschlusslinse (36) über das Dispenser-Gehäuse (40) hervorragt.

14. Verwendung nach einem der Ansprüche 1-12,
**dadurch gekennzeichnet, dass** das Dispenser-Gehäuse (40) eine Innenwandung (60) und eine die Innenwandung (60) umlaufende Außenwandung (62) aufweist, so dass die Innenwandung (60) dem Objektivgehäuse (30) zugewandt ist, und dass der Fluidraum (42) zwischen der Innenwandung (60) und der Außenwandung (62) gebildet ist, und dass die Innenwandung (60) ein Durchstrahlfenster (64) aus einem fluiddichten und optisch transparentem Material aufweist, welches der Abschlusslinse (36) zugewandt ist, wobei der Austrittspalt (44) zwischen dem Durchstrahlfenster (64) und der Außenwandung (62) gebildet ist.

15. Verwendung nach einem der vorherigen Ansprüche,
**dadurch gekennzeichnet, dass** das Dispenser-Gehäuse (40) wenigstens einen zusätzlicher Zugang (68) in den Fluidraum (42) aufweist, wobei der zusätzliche Zugang (68) zur Zuleitung von Fluiden oder Licht in den Fluidraum (42) ausgebildet ist.

## Claims

1. Use of a dispenser attachment (38), in particular a dispenser attachment (38) for microscopy objectives, in a device (10) for writing three-dimensional structures by means of laser lithography in a lithography fluid (22) which can be solidified by means of irradiation using laser light,
the device (10) comprising:
- a laser beam source (12) for emitting a writing beam (14) ;
- a substrate (24) for receiving lithography fluid (22) ;
- an objective (18) for forming a focus region (20) of the writing beam (14) in the lithography fluid (22), the objective (18) comprising an objective housing (30) and an exit lens (36);
the dispenser attachment (38) comprising:
- a dispenser housing (40) which is designed to be placed on the objective (18) such that a fluid space (42) is formed between the objective housing (30) and the dispenser housing (40) and such that an outlet gap (44) is formed between the dispenser housing (40) and the exit lens (36); and
- a fluid inlet (50) into the fluid space (42),
wherein the following steps are carried out for use:
- providing a lithography fluid (22) which is adapted to the laser beam source (12) such that solidification takes place only in the focus region (20) and using a multi-photon process;
- supplying the lithography fluid (22) through the fluid inlet (50) into the fluid space (42);
- applying a volume of lithography fluid (22) through the outlet gap (44);
- introducing the writing beam (14) through the objective (18) into the volume of lithography fluid (22) and locally solidifying the lithography fluid (22) in the focus region (20) by means of a multi-photon process for writing the three-dimensional structure.

2. Use according to claim 1, wherein the application step is carried out such that the lithography fluid (22) remains in contact with the exit lens (36) and the writing beam (14) is introduced into the lithography fluid (22) while the lithography fluid (22) is in contact with the exit lens (36).

3. Use according to claim 1 or 2, wherein the application step is carried out such that the lithography fluid (22) remains in contact with the substrate (24) on one side and with the exit lens (36) on the other side.

4. Use according to any of the preceding claims, wherein a first lithography fluid (22) is provided and is supplied through the fluid inlet (50) into the fluid space (42), and a first volume of the first lithography fluid (22) is applied through the outlet gap (44),
and wherein a second lithography fluid (22) is provided thereafter and is supplied through the fluid inlet (50) into the fluid space (42), and a second volume of the second lithography fluid (22) is applied through the outlet gap (44).

5. Use according to claim 4, wherein the first lithography fluid (22) and the second lithography fluid (22) are different materials having different material properties.

6. Use according to claim 4 or 5, wherein, after applying the first lithography fluid (22) and before applying the second lithography fluid (22), at least one step of introducing the writing beam (14) into the volume of first lithography fluid (22) and locally solidifying the first lithography fluid (22) takes place.

7. Use according to claim 4 or 5, wherein the first lithography fluid (22) is applied first and then the second lithography fluid (22) is applied, and then the first lithography fluid and the second lithography fluid are mixed.

8. Use according to any of the preceding claims, wherein, after the step of introducing the writing beam (14) and the locally solidifying the lithography fluid (22), the following steps are carried out:
- providing a developer fluid to expose and/or harden the written three-dimensional structure;
- supplying the developer fluid through the fluid inlet (50) into the fluid space (42);
- applying a volume of developer fluid through the outlet gap.

9. Use according to any of the preceding claims, comprising the following step:
- providing and supplying compressed gas through the fluid inlet (50) or through an additional inlet (68) into the fluid space (42).

10. Use according to any of the preceding claims, comprising the following step:
- providing cleaning fluid which is designed to dissolve unsolidified and solidified lithography fluid (22) ;
- supplying the cleaning fluid through the fluid inlet (50) or through an additional inlet (68) into the fluid space (42);
- ejecting cleaning fluid through the outlet gap (44).

11. Use according to any of the preceding claims, comprising the following step:
- introducing light into the fluid space (42), in particular by means of a light guide leading into the fluid space (42).

12. Use according to any of the preceding claims, wherein an immersion objective is used as the objective (18).

13. Use according to any of the preceding claims, **characterized in that** the dispenser housing (40) is designed such that the exit gap (44) is an annular gap around the exit lens (36), the annular gap being delimited by a peripheral edge (58) of the dispenser housing (40) such that the exit lens (36) protrudes beyond the dispenser housing (40).

14. Use according to any of claims 1 to 12, **characterized in that** the dispenser housing (40) has an inner wall (60) and an outer wall (62) which surrounds the inner wall (60) so that the inner wall (60) faces the objective housing (30), and **in that** the fluid space (42) is formed between the inner wall (60) and the outer wall (62), and **in that** the inner wall (60) has a transmission window (64) made of a fluid-tight and optically transparent material which faces the exit lens (36), the outlet gap (44) being formed between the transmission window (64) and the outer wall (62).

15. Use according to any of the preceding claims, **characterized in that** the dispenser housing (40) has at least one additional inlet (68) into the fluid space (42), the additional inlet (68) being designed to convey fluids or light into the fluid space (42).

## Revendications

1. Utilisation d'un adaptateur de distributeur (38), en particulier d'un adaptateur de distributeur (38) pour des objectifs de microscopie, dans un dispositif (10) d'écriture de structures tridimensionnelles au moyen de lithographie laser dans un fluide de lithographie (22) qui peut être solidifié par irradiation avec de la lumière laser,
le dispositif (10) comprenant:
- une source de faisceau laser (12) pour émettre un faisceau d'écriture (14);
- un substrat (24) pour recevoir du fluide de lithographie (22),
- un objectif (18) pour former une zone de focalisation (20) du faisceau d'écriture (14) dans le fluide de lithographie (22), l'objectif (18) comprenant un boîtier d'objectif (30) et une lentille terminale (36) ;
ledit adaptateur de distributeur (38) comprenant:
- un boîtier de distributeur (40) qui est conçu pour être placé sur l'objectif (18) de telle sorte qu'un espace de fluide (42) est formé entre le boîtier d'objectif (30) et le boîtier de distributeur (40) et qu'une fente de sortie (44) est formée entre le boîtier de distributeur (40) et la lentille terminale (36),
- et un accès de fluide (50) dans ledit espace de fluide (42);
dans lequel pour l'utilisation sont réalisées les étapes suivantes consistant à:
- fournir un fluide de lithographie (22) qui est adapté à la source de faisceau laser (12) de telle sorte que la solidification a lieu uniquement dans la zone de focalisation (20) et en utilisant un processus multiphotonique;
- amener le fluide de lithographie (22) par l'accès de fluide (50) dans l'espace de fluide (42);
- appliquer un volume de fluide de lithographie (22) par la fente de sortie (44);
- introduire le faisceau d'écriture (14) par l'objectif (18) dans le volume de fluide de lithographie (22) et solidifier localement le fluide de lithographie (22) dans la zone de focalisation (20) par un processus multiphotonique d'écriture de la structure tridimensionnelle.

2. Utilisation selon la revendication 1, dans laquelle l'étape d'application se fait de telle sorte que le fluide de lithographie (22) reste en contact avec la lentille terminale (36) et le faisceau d'écriture (14) est introduit dans le fluide de lithographie (22) tandis que le fluide de lithographie (22) est en contact avec la lentille terminale (36).

3. Utilisation selon la revendication 1 ou 2, dans laquelle l'étape d'application se fait de telle sorte que le fluide de lithographie (22) reste en contact avec le substrat (24) d'une part et avec la lentille terminale (36) d'autre part.

4. Utilisation selon l'une quelconque des revendications précédentes, dans laquelle un premier fluide de lithographie (22) est fourni, est amené par l'accès de fluide (50) dans l'espace de fluide (42), et un premier volume du premier fluide de lithographie (22) est appliqué par la fente de sortie (44),
et dans lequel un deuxième fluide de lithographie (22) est ensuite fourni, est amené par l'accès de fluide (50) dans l'espace de fluide (42) et un deuxième volume du deuxième fluide de lithographie (22) est appliqué par la fente de sortie (44).

5. Utilisation selon la revendication 4, dans laquelle le premier fluide de lithographie (22) et le deuxième fluide de lithographie (22) sont des matériaux différents ayant des propriétés matérielles différentes.

6. Utilisation selon la revendication 4 ou 5, dans laquelle, après avoir appliqué le premier fluide de lithographie (22) et avant d'appliquer le deuxième fluide de lithographie (22), au moins une étape consistant à introduire le faisceau d'écriture (14) dans le volume de premier fluide de lithographie (22) et une solidification locale du premier fluide de lithographie (22) ont lieu.

7. Utilisation selon la revendication 4 ou 5, dans laquelle d'abord le premier fluide de lithographie (22) est appliqué et puis le deuxième fluide de lithographie (22) est appliqué, et ensuite le premier fluide de lithographie et le deuxième fluide de lithographie sont mélangés.

8. Utilisation selon l'une quelconque des revendications précédentes, dans laquelle après l'étape d'introduction du faisceau d'écriture (14) et de solidification locale du fluide de lithographie (22), les étapes suivantes sont mises en oeuvre:
- fournir un fluide révélateur pour exposer et/ou durcir la structure tridimensionnelle écrite;
- amener le fluide révélateur par l'accès de fluide (50) dans l'espace de fluide (42);
- appliquer un volume de fluide révélateur par la fente de sortie.

9. Utilisation selon l'une quelconque des revendications précédentes, comprenant l'étape suivante consistant à:
- fournir et amener du gaz comprimé par l'accès de fluide (50) ou par un accès supplémentaire (68) dans l'espace de fluide (42).

10. Utilisation selon l'une quelconque des revendications précédentes, comprenant l'étape suivante consistant à:
- fournir un fluide de nettoyage qui est conçu pour dissoudre du fluide de lithographie (22) non solidifié et solidifié;
- amener le fluide de nettoyage par l'accès de fluide (50) ou par un accès supplémentaire (68) dans l'espace de fluide (42);
- évacuer du liquide de nettoyage par la fente de sortie (44).

11. Utilisation selon l'une quelconque des revendications précédentes, comprenant l'étape suivante consistant à:
- introduire de la lumière dans l'espace de fluide (42), en particulier au moyen d'un guide de lumière débouchant dans l'espace de fluide (42).

12. Utilisation selon l'une quelconque des revendications précédentes, dans laquelle un objectif à immersion est utilisée comme objectif (18).

13. Utilisation selon l'une quelconque des revendications précédentes, **caractérisé par le fait que** le boîtier de distributeur (40) est conçu de telle sorte que la fente de sortie (44) est une fente annulaire autour de la lentille terminale (36), dans laquelle la fente annulaire est délimitée par un bord périphérique (58) du boîtier de distributeur (40) de telle sorte que la lentille terminale (36) dépasse du boîtier du distributeur (40).

14. Utilisation selon l'une quelconque des revendications 1 à 12, **caractérisée par le fait que** le boîtier de distributeur (40) présente une paroi intérieure (60) et une paroi extérieure (62) entourant la paroi intérieure (60) de sorte que la paroi intérieure (60) montre en direction du boîtier d'objectif (30), et que ledit espace de fluide (42) est formé entre la paroi intérieure (60) et la paroi extérieure (62), et que la paroi intérieure (60) présente une fenêtre de transmission (64) constituée d'un matériau étanche aux fluides et optiquement transparent, qui montre en direction de la lentille terminale (36), dans laquelle la fente de sortie (44) est formée entre la fenêtre de transmission (64) et la paroi extérieure (62).

15. Utilisation selon l'une quelconque des revendications précédentes, **caractérisée par le fait que** le boîtier de distributeur (40) présente au moins un accès supplémentaire (68) dans l'espace de fluide (42), dans laquelle l'accès supplémentaire (68) est conçu pour amener des fluides ou de la lumière dans l'espace de fluide (42).
